# EUROPÄISCHE PATENTSCHRIFT

(11) **EP 0 298 251 B1**
(45) Veröffentlichungstag und Bekanntmachung des Hinweises auf die Patenterteilung: **17.08.1994**
(21) Anmeldenummer: 88108723.3
(22) Anmeldetag: 31.05.1988
(51) Int. Cl.: H01L 27/10, H01L 21/82

(54) **Hochintegrierbare Speicherzelle und Verfahren zu ihrer Herstellung**
High-density memory cell and process for manufacturing
Cellule ou mémoire à haute densité et procédé pour fabriquer

(30) Priorität: 10.07.1987 DE 3722939
(43) Veröffentlichungstag der Anmeldung: 11.01.1989
(73) Patentinhaber: SIEMENS AKTIENGESELLSCHAFT, 80333 München (DE)
(72) Erfinder: Risch, Lothar, Dr., Dipl.-Phys., D-8012 Ottobrunn (DE); Tielert, Reinhard, Dr. Ing., Dipl.-Phys., D-8000 München 82 (DE)

(56) Entgegenhaltungen:
- EP-A- 0 234 891
- PATENT ABSTRACTS OF JAPAN, Band 11, Nr. 195 (E-518)[2642], 23. Juni 1987;& JP-A-62 023 153
- IEEE JOURNAL OF SOLID-STATE CIRCUITS, Band SC-21, Nr. 5, Oktober 1986, Seiten605-611, IEEE, New York, US; T. FURUYAMA et al.: "An experimental 4-Mbit CMOSDRAM"

## Beschreibung

Die Erfindung bezieht sich auf eine hochintegrierbare Speicherzelle nach dem Oberbegriff des Patentanspruchs 1 und auf ein Verfahren zur Herstellung derselben.

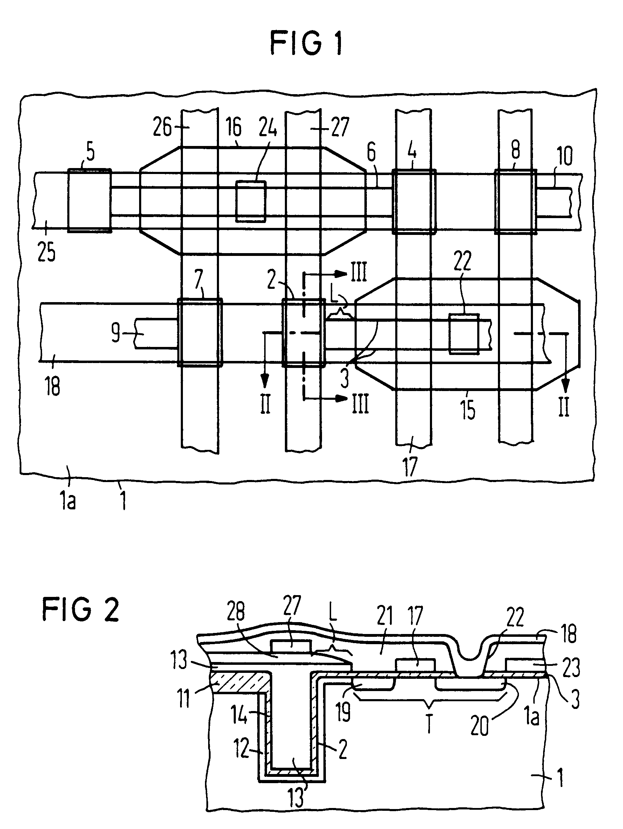

Eine Speicherzelle dieser Art ist aus dem IEEE Journal of Solid-State Circuits, Vol. SC-21, No. 5, Okt. 1986, S. 605-611, insbesondere Fig. 1, bekannt. Der an den Graben in lateraler Richtung angrenzende planare aktive Bereich der Speicherzelle umschließt hierbei den gesamten Grabenrand, so daß die laterale Begrenzung des Grabens unter Einhaltung eines Justierabstandes innerhalb der lateralen Begrenzung des aktiven Bereichs liegt. Durch den Justierabstand wird erreicht, daß nach dem Plazieren des aktiven Bereichs der Speicherzelle auf dem Halbleiterkörper die Position einer Maske, die die lateralen Grenzen des Grabens definiert, gegenüber ihrer Sollage um einen Betrag differieren kann, der kleiner ist als der genannte Justierabstand, ohne daß die durch die Grabenwandung vergrößerte Speicherkapazität in unzulässiger Weise von ihrem Sollwert abweicht. Die Einhaltung des Justierabstandes zwischen dem Grabenrand und der lateralen Begrenzung des aktiven Bereichs bedingt aber eine Vergrößerung des Flächenbedarfs der Speicherzelle.

Der Erfindung liegt die Aufgabe zugrunde, eine Speicherzelle der eingangs genannten Art anzugeben, die trotz einer Verringerung des Flächenbedarfs gegenüber den herkömmlichen Speicherzellen einen vergleichbaren Kapazitätswert des Speicherkondensators gewährleistet. Das wird erfindungsgemäß durch eine Ausbildung nach dem Kennzeichen des Patentanspruchs 1 erreicht.

Der mit der Erfindung erzielbare Vorteil liegt insbesondere darin, daß der außerhalb des Grabens liegende Teil des aktiven Bereichs der Speicherzelle gegenüber den bekannten Speicherzellen wesentlich verringert ist, da er den Graben nicht mehr vollständig umgibt. Bestimmte, einem vorgegebenen Justierabstand entsprechende Dejustierungen des Grabens gegenüber dem aktiven Bereich der Speicherzelle führen im übrigen bei der Herstellung der erfindungsgemäßen Speicherzelle noch zu keiner Größenabweichung des Speicherkondensators, wie das bei den bekannten Speicherzellen der eingangs genannten Art der Fall ist.

Die Ansprüche 2 bis 6 sind auf bevorzugte Ausgestaltungen und Weiterbildungen der Erfindung gerichtet. Der Anspruch 7 gibt ein vorteilhaftes Verfahren zur Herstellung einer erfindungsgemäßen Speicherzelle an.

Die Erfindung wird nachfolgend anhand der Zeichnung näher erläutert. Dabei zeigt:
- Fig. 1: den Entwurf einer nach der Erfindung ausgebildeten Speicherzelle mit den angrenzenden Teilen eines aus einer Mehrzahl von solchen Speicherzellen bestehenden Speicherfeldes,
- Fig. 2: einen Querschnitt durch die Speicherzelle nach Fig. 1 längs der Linie II - II,
- Fig. 3: einen Querschnitt durch die Speicherzelle nach Fig. 1 längs der Linie III - III und
- Fig. 4: eine Maskenfolge zur Herstellung einer Speicherzelle nach Fig. 1.

Die Figuren 1 und 2 zeigen einen Teil des aus einer Mehrzahl von erfindungsgemäßen Speicherzellen bestehenden Speicherfeldes eines dynamischen Halbleiterspeichers, das auf einem Körper 1 aus dotiertem Halbleitermaterial, z.B. Si, integriert ist. In der Draufsicht der Fig. 1 läßt sich eine Rechteckstruktur 2 erkennen, an die sich rechtsseitig ein horizontal verlaufender Streifen 3 anschließt. 2 stellt hierbei die laterale Begrenzung eines Grabens (trench) dar, der sich ausgehend von der Grenzfläche 1a des Halbleiterkörpers 1 in diesen hinein erstreckt. Die Wandung des Grabens 2 bildet im wesentlichen den Speicherbereich einer nach der Erfindung ausgebildeten Speicherzelle, während der Streifen 3 den außerhalb von 2 liegenden aktiven Bereich dieser Speicherzelle definiert. In diesem aktiven Bereich liegt ein zur Auswahl der Speicherzelle dienender Feldeffekttransistor. Zwei weitere gleichartig aufgebaute Speicherzellen sind in Fig. 1 durch die Gräben 4 und 5 angedeutet, ihre aktiven Bereiche durch einen diese Gräben miteinander verbindenden horizontalen Streifen 6. Die Gräben zweier weiterer Speicherzellen sind mit 7 und 8 bezeichnet, ihre aktiven Bereiche jeweils mit 9 und 10.

Im einzelnen ist der Halbleiterkörper 1, der z.B. aus p-leitendem Silizium besteht, auf seiner Grenzfläche 1a ganzflächig mit einer Isolierschicht überdeckt, die einzelne, den Speicherzellen individuell zugeordnete Dünnschichtbereiche aufweist. Diese sind mit den streifenförmigen Bereichen 3, 6, 9 und 10 identisch. Außerhalb derselben weist die Isolierschicht einen in sich geschlossenen Dickschichtbereich auf, wenn man von den durch die Gräben 2, 4, 5, 7 und 8 entstandenen Aussparungen absieht. Bei einer Ausbildung der Isolierschicht aus SiO₂ bezeichnet man die Dünnschichtbereiche 3, 6, 9 und 10 auch als Gateoxidschichten, die außerhalb derselben liegenden Teile der SiO₂-Schicht als Feldoxidschicht. In Fig. 2 ist die Gateoxidschicht 3 rechts neben dem Graben 2 zu erkennen, die Feldoxidschicht 11 links neben demselben. Im folgenden werden ausschließlich die Bezeichnungen Gateoxidschicht und Feldoxidschicht verwendet.

Wie Fig. 2 erkennen läßt, wird die Wandung des Grabens 2 zweckmäßigerweise mit einer sog. Grabendotierung versehen, die einen den Graben 2 umgebenden Halbleiterbereich 12 mit einem zum Halbleiterkörper 1 entgegengesetzten Leitfähigkeitstyp erzeugt. Im betrachteten Fall handelt es sich um einen n-leitenden Bereich 12. Ganz allgemein stellt die Wandung des Grabens 2 oder gegebenenfalls der Halbleiterbereich 12 die erste Elektrode eines Speicherkondensators dar. Die zweite Elektrode desselben wird durch eine erste elektrisch leitende Schicht 13 gebildet, die sowohl die Wandung des Grabens 2 als auch einen angrenzenden Teil des Gateoxidbereiches 3 auf einer Länge L sowie weiterhin große Teile der Feldoxidschicht 11 bedeckt. Zweckmäßigerweise besteht die Schicht 13 aus einer ersten hochdotierten Schicht aus polykristallinem Silizium. Sie ist durch eine dünne Isolierschicht 14 von der Wandung des Grabens 2 getrennt, wobei 14 mit den Gateoxidschichten 3, 6, 9 und 10 in ein und demselben Oxidationsschritt erzeugt wird. Die laterale Ausdehnung der Schicht 13 ist am besten anhand von Fig. 1 zu erkennen, wenn man beachtet, daß mit 15 und 16 zwei achteckige Ausnehmungen dieser Schicht angedeutet sind und alle außerhalb von 15 und 16 liegenden Teile der Feldoxidschicht 11 und der Gateoxidschichten 3, 6, 9 und 10 von der Schicht 13 überdeckt sind.

Innerhalb der Ausnehmung 15 liegt ein zur Selektion der Speicherzelle 2, 3 dienender Feldeffekttransistor T, der über eine Wortleitung 17 angesteuert wird und die wahlweise Anschaltung dieser Speicherzelle an eine Bitleitung 18 bewirkt. Im einzelnen besteht T aus einem Drain- bzw. Sourcebereich 19 und einem Source- bzw. Drainbereich 20, die beide n⁺-dotiert sind. Von diesen steht der Bereich 19 mit dem Halbleiterbereich 12 in Verbindung. Der zwischen 19 und 20 an der Oberfläche des Halbleiterkörpers 1 liegende Kanalbereich des Transistors T ist von einem Gate überdeckt, das aus einem Teil der Wortleitung 17 besteht und durch die Gateoxidschicht 3 von der Grenzfläche 1a getrennt ist. Die Wortleitung 17, die zweckmäßigerweise aus einer zweiten Schicht aus polykristallinem Silizium gebildet ist, wird durch eine Zwischenisolierschicht 21 abgedeckt. Die Bitleitung 18, die z. B. aus Al besteht, kontaktiert das Gebiet 20 im Bereich eines Kontaktloches 22 der Zwischenisolierschicht 17 und der Gateoxidschicht 3.

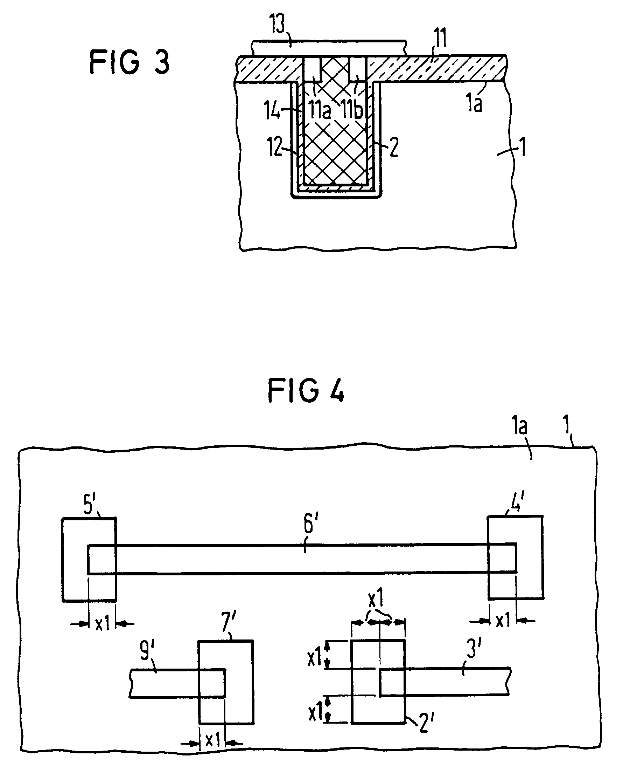

Fig. 3 zeigt zur weiteren Verdeutlichung des Erfindungsgedankens einen Querschnitt durch den Speicherkondensator 12, 13 entlang der Linie III - III von Fig. 1 in schematischer Darstellung. Man erkennt, daß der Graben 2 an seinem in der Grenzfläche 1a liegenden Rand von der Feldoxidschicht 11 und unterhalb von 11 von dem n⁺-dotierten Bereich 12 umgeben ist. Die leitende Belegung 13 ist aus Gründen einer übersichtlichen Darstellung nur oberhalb der Feldoxidschicht 11 dargestellt, füllt aber auch den Innenraum des mit der dünnen Isolierschicht 14 ausgekleideten Grabens 2 aus. An der in Fig. 3 sichtbaren, dem aktiven Bereich 3 zugekehrten Wandung des Grabens 2 erkennt man Teile 11a und 11b der Feldoxidschicht 11, die den zur Speicherkapazität beitragenden Teil dieser Wandung auf die doppelt schraffierte Fläche begrenzen. Die oberhalb der Grenzfläche 1a gemessene Breite der doppelt schraffierten Fläche entspricht der Breite der Gateoxidschicht 3.

Im Betrieb wird die Elektrode 13 des Speicherkondensators mit einer festen Spannung beaufschlagt. Bei einer Selektion der Speicherzelle 2, 3 wird die Wortleitung 17 mit einer Spannung belegt, durch die T in den leitenden Zustand gelangt. Damit werden beim Auftreten eines ersten logischen Signals auf der Bitleitung 18 Ladungsträger über den leitenden Transistor T in den Halbleiterbereich 12 transportiert, beim Auftreten eines zweiten logischen Signals auf der Bitleitung dagegen nicht. Durch den erreichten Ladungszustand des Speicherkondensators 12, 13 ist dann das betreffende logische Signal in der Speicherzelle 2, 3 gespeichert. Zum Auslesen dieser Zelle wird der Transistor T wieder leitend geschaltet und der Ladungszustand des Speicherkondensators 12, 13 über die zuvor auf ein bestimmtes Potential gebrachte Bitleitung abgefragt. Dieses Potential ist so gewählt, daß etwaige im Speicherkondensator 12, 13 gespeicherte Ladungsträger eine Potentialänderung auf der Bitleitung in einer Richtung bewirken, während andererseits beim Verbinden der Bitleitung mit einem nicht geladenen Speicherkondensator das Potential in der entgegengesetzten Richtung verändert wird.

Der beschriebene Aufbau der Speicherzelle 2, 3, der dadurch gekennzeichnet ist, daß der unterhalb der Gateoxidschicht 3 liegende aktive Bereich der Speicherzelle mit seiner stirnseitigen Begrenzung einen Teil des Randes des Grabens 2 bildet, während der übrige Teil des Grabenrandes unmittelbar vom Feldoxidbereich 11 umgeben ist, reduziert den erforderlichen Flächenbedarf der Speicherzelle ganz wesentlich, da sich außerhalb der in Fig. 1 gezeichneten linken, oberen und unteren Begrenzung des Grabens 2 kein Teil der Gateoxidschicht 3 befindet. Daher kann auch der Graben 7 der nächsten unterhalb derselben Bitleitung 18 angeordneten Speicherzelle 7, 9 wesentlich näher am Graben 2 plaziert werden, als das bei den herkömmlichen Speicherzellen dieser Art, bei denen die Gateoxidschicht 3 den Graben 2 vollständig umschließt, möglich wäre.

Wie aus Fig. 2 ersichtlich ist, werden jeweils zwei benachbarte, unter ein und derselben Bitleitung, z.B. 18, liegende Speicherzellen in der Weise zu einem Speicherzellenpaar zusammengefaßt, daß ihre Feldeffekttransistoren ein gemeinsames Source- bzw. Draingebiet 20 aufweisen. In Fig. 2 ist das Gate des Feldeffekttransistors, der zu der rechts vom Gebiet 20 liegenden Speicherzelle gehört, mit 23 bezeichnet. Fig. 1 zeigt, daß auch die Feldeffekttransistoren der weiteren Speicherzellen, z.B. 4, 6 und 5, 6, ein gemeinsames Source- bzw. Draingebiet aufweisen, das im Bereich eines Kontaktloches 24 von einer diesen Speicherzellen gemeinsamen Bitleitung 25 kontaktiert wird. Die Wortleitungen 26 und 27, die zur Ansteuerung der Speicherzellen 5, 6 und 4, 6 dienen, verlaufen außerhalb der Ausnehmung 16 der leitenden Belegung 13 oberhalb einer Zwischenisolierschicht 28, durch die sie von der Belegung 13 getrennt sind. In gleicher Weise ist die Wortleitung 17 außerhalb der Ausnehmung 15 durch die Zwischenisolierschicht von der Belegung 13 getrennt.

Bei der Herstellung der erfindungsgemäßen Speicherzellen wird die Grenzfläche 1a lediglich im Bereich der mit 3′, 6′ und 9′ bezeichneten Flächenteile mit einer ersten Maske aus z.B. Si₃N₄ abgedeckt. Sämtliche außerhalb dieser Flächenteile liegenden Bereiche werden lokal oxidiert, wobei die Feldoxidschicht 11 gebildet wird. Das maskierte Flächenteil 3′ entspricht dabei lagemäßig dem Gateoxidbereich 3 (Fig. 1), allerdings mit dem Unterschied, daß es den Flächenteil 2′, der für den Graben 2 vorgesehen ist, um einen Betrag x1 überlappt. Analog hierzu sind auch die maskierten Flächenteile 6′ und 9′, die den späteren Gateoxidbereichen 6 und 9 lagemäßig entsprechen, endseitig jeweils um den Betrag x1 verlängert. Nach dem Entfernen der ersten Maske folgt ein maskierter Ätzschritt, bei dem eine zweite Maske die Grenzfläche 1a bis auf die Flächenanteile 2′, 4′, 5′ und 7′ abdeckt und die Gräben 2, 4, 5 und 7 in den Halbleiterkörper 1 eingeätzt werden. Die zweite Maske kann dabei in horizontaler und/oder vertikaler Richtung jeweils um den Betrag x1 gegenüber ihrer Sollage dejustiert sein, ohne daß hierdurch die Kapazitätswerte der einzelnen Speicherkondensatoren von ihrem Sollwert abweichen.

Nach dem Plazieren der Gräben 2, 4, 5 und 7 und nach dem Entfernen der zweiten Maske werden zunächst die Grabendotierungen vorgenommen, wodurch die die Gräben umgebenden Halbleiterbereiche, z.B. 12, gebildet werden. Es folgt das Aufwachsen der Gateoxidschichten, z.B. 3, in an sich bekannter Weise auf den Flächenteilen 3′, 6′ und 9′ und der dünnen Isolierschichten, z.B. 14, auf den Wandungen der Gräben 2, 4, 5 und 7. Anschließend wird ganzflächig eine leitende Belegung 13 abgeschieden, bei der es sich vorzugsweise um eine erste hochdotierte Schicht aus polykristallinem Silizium handelt. Diese wird ganzflächig mit der Zwischenisolationsschicht 28 überdeckt, wobei anschließend mittels fotolithografischer Schritte die Teile 15 und 16 der leitenden Belegung 13 und die darüberliegenden Teile der Zwischenisolationsschicht 28 wieder entfernt werden. Es folgt das Aufbringen einer zweiten leitenden Belegung, insbesondere einer zweiten hochdotierten polykristallinen Siliziumschicht, aus der mittels fotolithografischer Schritte die Wortleitungen 17, 23, 26 und 27 gebildet werden. Anschließend werden die Gebiete 19 und 20 mittels einer Ionenimplantation erzeugt. Es folgt das Aufbringen der Zwischenisolationsschicht 21 und das Erzeugen der Kontaktlöcher, z.B. 22, in den Schichten 21 und 3. Schließlich wird auf der Zwischenisolationsschicht 21 eine weitere leitende Belegung, z.B. aus Al, aufgebracht, aus der mittels fotolithografischer Schritte die Bitleitungen, z.B. 18 und 25, gebildet werden.

Bei einer Speicherzelle nach Fig. 1 können die Abmessungen des Grabens 2 parallel zur Bitleitung 18 beispielsweise 0,8 µm und parallel zur Wortleitung 17 beispielsweise 1,4 µm betragen.

Bei einer Grabentiefe von etwa 6 µm, einer Wortleitungsbreite von etwa 0,8 µm, einem Abstand zwischen der Wortleitung 17 und dem Graben 2 von etwa 1 µm und einer Breite des aktiven Bereiches 3 von etwa 0,6 µm ergibt sich bei einer Speicherkapazität von etwa 30 bis 50 fF für die gesamte Speicherzelle 2,3 ein Flächenbedarf von etwa 7,2 µm², wobei die Flächenabmessungen parallel zur Richtung der Wortleitungen etwa 2 µm und parallel zur Richtung der Bitleitung etwa 3,6 µm betragen. Dabei wird ein Abstand von 1 µm zwischen zwei benachbarten, unter ein und derselben Bitleitung liegenden Gräben, z.B. 2 und 7, angenommen. Da für einen dynamischen Halbleiterspeicher mit einer Speicherkapazität von 4 Mbit etwa eine Halbleiterfläche von 10 bis 12 µm² pro Speicherzelle veranschlagt wird, kann ein solcher Speicher mit erfindungsgemäßen Zellen bei verkleinerter Fläche aufgebaut werden. Legt man für einen dynamischen Halbleiterspeicher mit einer Speicherkapazität von 16 Mbit etwa einen Flächenbedarf von 4 bis 6 µm² pro Speicherzelle zugrunde, so kann das erfinderische Zellenkonzept mit etwas verschärften Designregeln auch hierfür verwendet werden.

## Patentansprüche

1. Hochintegrierbare Speicherzelle, bestehend aus einem Feldeffekttransistor (T) und aus einem Speicherkondensator, die zusammen auf einem Halbleiterkörper (1) eines ersten Leitungstyps derart integriert sind, daß ein erster Anschluß des Feldeffekttransistors mit einer Bitleitung (18) verbunden und das Gate des Feldeffekttransistors über eine Wortleitung (17) ansteuerbar sind,
- mit einer ersten Elektrode des Speicherkondensators, die aus der Wandung eines in den Halbleiterkörper (1) eingefügten Grabens (2) gebildet wird und mit einem zweiten Anschluß des Feldeffekttransistors verbunden ist,
- mit einer die Grenzfläche (1a) des Halbleiterkörpers bedeckenden Isolierschicht (3, 11), die aus einem Dünnschichtbereich (3) und einem Dickschichtbereich (11) besteht, wobei der Dünnschichtbereich (3) den außerhalb des Grabens (2) liegenden Teil des aktiven Bereichs der Speicherzelle definiert, an einer Seite von dem Graben (2) begrenzt wird und an den anderen Seiten von dem Dickschichtbereich (11) umgeben ist,
- mit einer dünnen Isolierschicht (14), die die Wandung des Grabens (2) überdeckt und
- mit einer Schicht (13) aus elektrisch leitendem Material, die die Isolierschicht (3, 11) an der Grenzfläche (1a) des Halbleiterkörpers und die dünne Isolierschicht (14) der Wandung des Grabens überdeckt und die die zweite auf Bezugspotential liegende Elektrode des Speicherkondensators darstellt,
**dadurch gekennzeichnet,**
daß der Dünnschichtbereich (3) streifenförmig ausgebildet ist,
daß die grabenseitige Begrenzung des von diesem definierten Teils des aktiven Bereichs einen Teil des Randes des Grabens (2) bildet und
daß der übrige Teil des Randes des Grabens (2) unmittelbar vom Dickschichtbereich (11) der Isolierschicht (3, 11) umgeben ist.

2. Hochintegriertbare Speicherzelle nach Anspruch 1, **dadurch gekennzeichnet,** daß die grabenseitige Begrenzung des vom Dünnschichtbereich (3) definierten Teils des aktiven Bereichs kleiner bemessen ist als die dem aktiven Bereich zugekehrte Seite des eine rechteckige Form aufweisenden Randes des Grabens (2).

3. Hochintegrierbare Speicherzelle nach Anspruch 1 oder 2, **dadurch gekennzeichnet,** daß die Wandung des Grabens (2) von einem Halbleiterbereich (12) eines zweiten Leitungstyps umgeben ist.

4. Hochintegrierbare Speicherzelle nach einem der Ansprüche 1 bis 3, **dadurch gekennzeichnet,** daß der Feldeffekttransistor (T) zwei durch einen Kanalbereich des ersten Leitungstyps voneinander getrennte Halbleitergebiete (19, 20) des zweiten Leitungstyps aufweist, von denen das eine (19) mit der ersten Elektrode des Speicherkondensators (12, 13) verbunden ist und das zweite (20) mit einer Bitleitung (18) in Verbindung steht, und daß der Kanalbereich von einem Gate (17) überdeckt ist, das aus einem Teil einer Wortleitung besteht und durch einen Teil des Dünnschichtbereiches (3) von der Grenzfläche (1a) des Halbleiterkörpers (1) getrennt ist.

5. Hochintegrierbare Speicherzelle nach Anspruch 4, **dadurch gekennzeichnet,** daß sie mit einer zweiten, gleichartig aufgebauten Speicherzelle derart zu einem Speicherzellenpaar zusammengefaßt ist, daß die Feldeffekttransistoren (T) beider Speicherzellen ein gemeinsames, mit einer Bitleitung (18) in Verbindung stehendes Halbleitergebiet (20) des zweiten Leitungstyps aufweisen.

6. Hochintegrierbare Speicherzellen nach Anspruch 5, **dadurch gekennzeichnet,** daß sie zu mehreren Gruppen von Speicherzellenpaaren zusammengefaßt sind, wobei innerhalb jeder dieser Gruppen die Feldeffekttransistoren (T) sämtlicher Speicherzellen mit einer gruppenspezifischen Bitleitung (18) verbunden sind und wobei die einzelnen Gruppen von Speicherzellenpaaren zusammen mit den gruppenspezifischen Bitleitungen auf dem Halbleiterkörper (1) jeweils zeilenweise nebeneinander angeordnet sind.

7. Verfahren zum Herstellen einer hochintegrierbaren Speicherzelle nach einem der vorhergehenden Ansprüche, wobei die Grenzfläche (1a) des Halbleiterkörpers (1) eines ersten Leitungstyps mit einer ersten Maske belegt wird, die lediglich den dem aktiven Bereich der Speicherzelle lagemäßig entsprechenden Flächenteil (3′) bedeckt, wobei dieser Flächenteil (3′) um ein vorgegebenes Maß (x1) den für den Graben (2) vorgesehenen Flächenteil der Speicherzellenfläche überlappt; der von der ersten Maske nicht bedeckte Teil der Grenzfläche (1a) einer lokalen Oxidation unterzogen wird wobei der Dickschichtbereich (11) gebildet wird; neben dem Entfernen der ersten Maske unter Verwendung einer zweiten, den Graben definierenden Maske der Graben (2) in den Halbleiterkörper (1) eingeätzt wird; nach dem Entfernen der zweiten Maske mittels eines ersten Dotierungsschrittes ein den Graben umgebender Halbleiterbereich (12) eines zweiten Leitungstyps erzeugt wird; auf dem aktiven Bereich der Speicherzelle der Dünnschichtbereich (3) und auf der Wandung des Grabens (2) die dünne Isolierschicht (14) aufgewachsen werden; eine erste leitende Belegung (13) abgeschieden und mit einer ersten Zwischenisolationsschicht (28) überdeckt wird; ein den Bereich des Feldeffekttransistors (T) überdeckender Teil der ersten leitenden Belegung (13) und der ersten Zwischenisolationsschicht (28) durch fotolithografische Schritte entfernt wird; die Wortleitung (17) durch fotolithografische Schritte aus einer ganzflächig abgeschiedenen, zweiten leitenden Belegung gebildet wird; mittels eines zweiten Dotierungsschrittes das Source- und Draingebiet (20, 19) des Feldeffekttransistors (T) gebildet werden, die den zweiten Leitungstyp aufweisen; eine zweite Zwischenisolationsschicht (21) ganzflächig aufgebracht wird; oberhalb des einen mittels des zweiten Dotierungsschrittes gebildeten Gebiets (20) ein Kontaktloch (22) in der zweiten Zwischenisolationsschicht (21) und im Dünnschichtbereich (3) vorgesehen wird und nach dem Aufbringen einer weiteren leitenden Belegung aus dieser mittels fotolithografischer Schritte die Bitleitung (18) gebildet wird, die das letztgenannte, mittels des zweiten Dotierungsschrittes gebildete Gebiet (20) im Bereich des Kontaktloches (22) kontaktiert.

## Claims

1. Large-scale integrable memory cell, comprising a field effect transistor (T) and a storage capacitor which are integrated together on a semiconductor body (1) of a first conductivity type in such a way that a first terminal of the field effect transistor is connected to a bit line (18) and the gate of the field effect transistor can be driven via a word line (17),
- having a first electrode of the storage capacitor, which is formed by the wall of a trench (2) let into the semiconductor body (1) and is connected to a second terminal of the field effect transistor,
- having an insulating layer (3, 11) which covers the boundary surface (1a) of the semiconductor body and comprises a thin-film region (3) and a thick-film region (11), the thin-film region (3) defining the part of the active region of the memory cell lying outside the trench (2), is delimited on one side by the trench (2) and is surrounded by the thick-film region (11) on the other sides,
- having a thin insulating layer (14) which covers the wall of the trench (2), and
- having a layer (13) of electrically conductive material which covers the insulating layer (3, 11) on the boundary surface (1a) of the semiconductor body and the thin insulating layer (14) of the wall of the trench, and which constitutes the second electrode of the storage capacitor connected to reference potential,
characterized in that the thin-film region (3) is fashioned in the form of a strip, in that the trench-side delimitation of the part of the active region defined thereby forms one part of the edge of the trench (2), and in that the remaining part of the edge of the trench (2) is directly surrounded by the thick-film region (11) of the insulating layer (3, 11).

2. Large-scale integrable memory cell according to Claim 1, characterized in that the trench-side delimitation of the part of the active region defined by the thin-film region (3) is dimensioned to be smaller than the side of the edge of the trench (2) having a rectangular form which faces the active region.

3. Large-scale integrable memory cell according to Claim 1 or 2, characterized in that the wall of the trench (2) is surrounded by a semiconductor region (12) of a second conductivity type.

4. Large-scale integrable memory cell according to one of Claims 1 to 3, characterized in that the field effect transistor (T) has two semiconductor areas (19, 20) of the second conductivity type separated from one another by a channel region of the first conductivity type, one of which (19) is connected to the first electrode of the storage capacitor (12, 13) and the second (20) of which is connected to a bit line (18), and in that the channel region is covered by a gate (17) which comprises one part of a word line and is separated from the boundary surface (1a) of the semiconductor body (1) by a part of the thin-film region (3).

5. Large-scale integrable memory cell according to Claim 4, characterized in that it is combined with a second, identically constructed, memory cell to form a memory cell pair in such a way that the field effect transistors (T) of both memory cells have a common semiconductor area (20) of the second conductivity type which is connected to a bit line (18).

6. Large-scale integrable memory cells according to Claim 5, characterized in that they are combined to form a plurality of groups of memory cell pairs, in which within each of said groups the field effect transistors (T) of all the memory cells are connected to a group-specific bit line (18), and in which the individual groups of memory cell pairs are arranged together with the group-specific bit lines on the semiconductor body (1) next to one another in rows in each case.

7. Method for manufacturing a large-scale integrable memory cell according to one of the preceding claims, in which the boundary surface (1a) of the semiconductor body (1) of a first conductivity type is coated with a first mask that covers only the surface part (3') corresponding in position to the active region of the memory cell, said surface part (3') overlapping the surface part of the memory cell surface provided for the trench (2) by a predetermined amount (x1); the part of the boundary surface (1a) not covered by the first mask is subjected to a local oxidation, whereby the thick-film region (11) is formed; in addition to the removal of the first mask, the trench (2) is etched into the semiconductor body (1) using a second mask defining the trench; after the removal of the second mask by means of a first doping step a semiconductor region (12) of a second conductivity type which surrounds the trench is produced; the thin-film region (3) is grown on the active region of the memory cell and the thin insulating layer (14) is grown on the wall of the trench (2); a first conductive coating (13) is deposited and is covered by a first intermediate insulating layer (28); a part of the first conductive coating (13) that covers the region of the field effect transistor (T) and of the first intermediate insulating layer (28) is removed by photolithographic steps; the word line (17) is formed by photolithographic steps from a second conductive coating deposited over the whole surface; the source and drain areas (20, 19) of the field effect transistor (T), which are of the second conductivity type, are formed by means of a second doping step; a second intermediate insulating layer (21) is applied over the whole surface; a contact hole (22) is provided over the one area (20) formed by means of the second doping step in the second intermediate insulating layer (21) and in the thin-film region (3), and, after the application of a further conductive coating, the bit line (18) is formed therefrom by means of photolithographic steps, which bit line contacts the aforesaid area (20) formed by means of the second doping step in the region of the contact hole (22).

## Revendications

1. Cellule intégrable avec une haute densité d'intégration, constituée par un transistor à effet de champ (N) et un condensateur de mémoire, qui sont intégrés conjointement dans un corps semiconducteur (1) possédant un premier type de conductivité de sorte qu'une première borne du transistor à effet de champ est reliée à une ligne de transmission de bits (18) et que la grille du transistor à effet de champ peut être commandée par l'intermédiaire d'une ligne de transmission de mots (17), comportant
- une première électrode du condensateur de mémoire, qui est formée par la paroi d'un sillon (2) ménagé dans le corps semiconducteur (1) et est reliée à une seconde borne du transistor à effet de champ,
- une couche isolante (3, 11), qui recouvre la surface limite (1a) du corps semiconducteur et qui est constituée par une partie de couche mince (3) et une partie de couche épaisse (11), la partie de couche mince (3) définissant la partie de la région active de la cellule de mémoire qui est située à l'extérieur du sillon (2), est limitée d'un côté par le sillon (2) et est entourée sur les autres côtés, par la région de couche épaisse (11),
- une couche isolante mince (14), qui recouvre la paroi du sillon (2), et
- une couche (16) réalisée en un matériau électriquement conducteur, qui recouvre la couche isolante (3, 11) au niveau de la surface limite (1a) du corps semiconducteur et la couche isolante mince (14) de la paroi du sillon et représente la seconde électrode, placée au potentiel de référence, du condensateur de mémoire,
caractérisée par le fait
que la région de couche mince (3) est réalisée en forme de bande, et
que la limite, située du côté du sillon, de la partie définie par ladite région, de la région active forme une partie du bord du sillon (2), et
que l'autre partie du bord du sillon (2) est entourée directement par la région de couche épaisse (11) de la couche isolante (3, 11).

2. Cellule intégrable avec une haute densité d'intégration suivant la revendication 1, caractérisée par le fait que la limite, située du côté du sillon, de la partie, qui définit la région de couche mince (3), de la région active est dimensionnée de manière à avoir une dimension inférieure à celle du côté, tourné vers la région active, du bord du sillon (2), qui possède une forme rectangulaire.

3. Cellule intégrable avec une haute densité d'intégration suivant la revendication 1 ou 2, caractérisée par le fait que la paroi du sillon (2) est entourée par une région semiconductrice (12) possédant un second type de conductivité.

4. Cellule intégrable avec une haute densité d'intégration suivant l'une des revendications 1 à 3, caractérisée par le fait que le transistor à effet de champ (T) possède deux régions semiconductrices (19, 20) possédant le second type de conductivité, qui sont séparées l'une de l'autre par une région de canal possédant le premier type de conductivité et dont l'une (19) est reliée à la première électrode du condensateur de mémoire (12, 13) et dont la seconde (20) est reliée à une ligne de transmission de bits (18), et que la région du canal est recouverte par une grille (17), qui est constituée par une partie d'une ligne de transmission de mots et est séparée de la surface limite (1a) du corps semiconducteur (1), par une partie de la région de couche mince (3).

5. Cellule intégrable avec une haute densité d'intégration suivant la revendication 4, caractérisée par le fait qu'elle est réunie à une seconde cellule de mémoire possédant un même agencement, pour former un couple de cellules de mémoire, de telle sorte que les transistors à effet de champ (T) des deux cellules de mémoire possèdent une région semiconductrice commune (20) possédant le second type de conductivité et qui est reliée à une ligne de transmission de bits (18).

6. Cellules de mémoire intégrables avec une haute densité d'intégration suivant la revendication 5, caractérisées par le fait qu'elles sont réunies pour former plusieurs groupes de couples de cellules de mémoire, et qu'à l'intérieur de chacun de ces groupes, les transistors à effet de champ (T) de toutes les cellules de mémoire sont reliés à une ligne de transmission de bits (18) spécifique au groupe et les différents groupes de couples de cellules de mémoire sont disposés, conjointement avec les lignes de transmission de bits, spécifiques au groupe, sur le corps semiconducteur (1) et ce respectivement côte-à-côte suivant des lignes.

7. Procédé pour fabriquer une cellule pouvant être intégrable avec une haute densité d'intégration suivant l'une des revendications précédentes, selon lequel on recouvre la surface limite (1a) du corps semiconducteur (1) possédant un premier type de conductivité, avec un premier masque qui recouvre uniquement l'élément de surface (3') qui correspond, du point de vue position, à la région active de la cellule de mémoire, cet élément de surface (3') chevauche sur une distance prédéterminée (x1) l'élément, prévu pour le sillon (2), de la surface de la cellule de mémoire; on soumet la partie, non recouverte par le premier masque, de la surface limite (1a) à une oxydation locale, lors de laquelle est formée la région de couche épaisse (11); en dehors de l'élimination du premier masque on réalise par corrosion le sillon (2) dans le corps semiconducteur (1) moyennant l'utilisation d'un second masque définissant le sillon; après l'enlèvement du second masque, on produit, au moyen d'une première étape de dopage, une région semiconductrice (12) qui entoure le sillon et qui possède un second type de conductivité; on forme par croissance la région de couche mince (3) sur la région active de la cellule de mémoire et la couche isolante mince (14) sur la paroi du sillon (2); on dépose un premier revêtement conducteur (13) et on le recouvre par une première couche isolante intercalaire (28); on élimine une partie, qui recouvre la région du transistor à effet de champ (T) du premier revêtement conducteur (13) et de la première couche isolante intercalaire (28) en mettant en oeuvre des étapes photolithographiques; on forme la ligne de transmission de mots (17) au moyen d'étapes photolithographiques à partir d'un second revêtement conducteur, déposé sur toute la surface; au moyen d'une seconde étape de dopage, on forme les régions de source et de drain (20, 19) du transistor à effet de champ (T), qui possède le second type de conductivité; on dépose sur toute la surface une seconde couche isolante intercalaire (21); au dessus d'une région (20) formée au moyen d'une seconde étape de dopage, on forme un trou de contact (22) dans la seconde couche isolante intercalaire (21) et dans la région de couche mince (3), et après le dépôt d'un autre revêtement conducteur, on forme, à partir de ce revêtement, et au moyen d'étapes photolithographiques, la ligne de transmission de bits (18), qui est en contact avec la région (20) indiquée en dernier lieu et qui est formée au moyen de la seconde étape de dopage, dans la zone du trou de contact (22).
